# EUROPÄISCHE PATENTSCHRIFT

(11) **EP 1 494 517 B1**
(45) Veröffentlichungstag und Bekanntmachung des Hinweises auf die Patenterteilung: **30.11.2005**
(21) Anmeldenummer: 03015219.3
(22) Anmeldetag: 04.07.2003
(51) Int. Cl.: H05K 5/00

(54) **Gehäuse zur Aufnahme eines Schaltungsträgers**
Casing for receiving a printed circuit board
Boîtier pour recevoir un circuit imprimé

(43) Veröffentlichungstag der Anmeldung: 05.01.2005
(73) Patentinhaber: Delphi Technologies, Inc., Troy, MI 48007 (US)
(72) Erfinder: Bergmann, Jürgen, 45665 Recklingshausen (DE)
(74) Vertreter: Manitz, Finsterwald & Partner GbR

(56) Entgegenhaltungen:
- EP-A- 0 838 882
- FR-A- 2 763 779
- US-A- 5 364 280

## Beschreibung

Die vorliegende Erfindung betrifft ein Gehäuse zur Aufnahme eines Schaltungsträgers, eine elektrische Vorrichtung mit einem Schaltungsträger und einem damit verbundenen Steckverbinder und ein Verfahren zur Herstellung und zum Anschluss einer solchen Vorrichtung.

Zum Schutz elektrischer Schaltungen werden diese häufig in entsprechende Gehäuse eingebaut. Zur Verbindung der elektrischen Schaltung mit elektrischen Leitungen außerhalb des Gehäuses ist meist in der Gehäusewand, beispielsweise in einer Öffnung der Gehäusewand, eine zur Herstellung einer Steckverbindung geeignete Geräteaufnahme vorgesehen, deren elektrische Kontaktelemente mit der elektrischen Schaltung elektrisch verbunden sind. Insbesondere in dem Fall, dass die Steckrichtung der Geräteaufnahme parallel zu einem beispielsweise als Platine ausgebildeten Schaltungsträger der elektrischen Schaltung ausgerichtet sein soll, können dazu bislang nur separate Geräteaufnahmen verwendet werden, die mechanisch und elektrisch auf dem Schaltungsträger befestigt werden müssen und nach Einsetzen des Schaltungsträgers in das Gehäuse in einer Öffnung des Gehäuses angeordnet sind.

Diese Lösung ist jedoch technisch sehr aufwändig, da die Geräteaufnahme als separates Bauteil zu handhaben ist und daher bei der Herstellung des Schaltungsträgers entsprechende Arbeitsschritte zur Befestigung der Geräteaufnahme auf dem Schaltungsträger notwendig sind. Darüber hinaus sind solche Geräteaufnahmen auch vergleichsweise teuer.

In US-A-5364280 ist eine elektrische Anschlussvorrichtung beschrieben, die eine starre Platine mit mehreren darauf angebrachten Anschlusselementen besitzt. Die Platine kann in einem Gehäuse angeordnet werden, das eine an einen Boden angelenkte Seitenwand aufweist. Die Seitenwand stellt ein Steckverbindergehäuse bereit, das dazu ausgebildet ist, eine Kante der Platine aufzunehmen, wobei die Anschlusselemente durch Öffnungen in der Seitenwand hervorstehen.

Der vorliegenden Erfindung liegt daher die Aufgabe zugrunde, Mittel, mittels derer eine elektrische Vorrichtung mit einem Schaltungsträger und einem mit dem Schaltungsträger elektrisch verbundenen Steckverbinderkörper einfach herstellbar ist, und eine solche Vorrichtung selbst bereitzustellen, sowie ein einfaches Verfahren zur Herstellung der elektrischen Vorrichtung zu schaffen.

Die Aufgabe wird gelöst durch eine elektrische Vorrichtung mit den Merkmalen des Anspruchs 1.

Die erfindungsgemäße elektrische Vorrichtung weist einen Schaltungsträger, der einen Schaltungsabschnitt und einen mit dem Schaltungsabschnitt mechanisch und elektrisch verbundenen, gegenüber dem Schaltungsabschnitt schwenkbaren Kontaktierungsabschnitt umfasst, und ein entsprechendes erfindungsgemäßes Gehäuse auf, wobei der Schaltungsträger wenigstens teilweise in dem Gehäuse aufgenommen ist und dessen Kontaktierungsabschnitt mit wenigstens einem Kontaktelement in dem Steckverbinderkörper des Gehäuses elektrisch verbunden ist.

Das erfindungsgemäße Gehäuse zur wenigstens teilweisen Aufnahme eines Schaltungsträgers, der einen Schaltungsabschnitt und einen mit dem Schaltungsabschnitt mechanisch und elektrisch verbundenen, gegenüber dem Schaltungsabschnitt schwenkbaren Kontaktierungsabschnitt umfasst, weist einen Aufnahmeabschnitt zur Aufnahme wenigstens des Schaltungsabschnitts des Schaltungsträgers und einen mit dem Aufnahmeabschnitt schwenkbar verbundenen Schwenkabschnitt mit einem Steckverbinderkörper zur Aufnahme von mit dem Kontaktierungsabschnitt elektrisch zu verbindenden oder verbundenen Kontaktelementen auf, wobei der Schwenkabschnitt aus einer Verbindungslage, in der der Kontaktierungsabschnitt elektrisch mit in dem Steckverbinderkörper gehaltenen Kontaktelementen verbindbar ist oder an dem Kontaktierungsabschnitt bereits gehaltene Kontaktelemente in den Steckverbinderkörper des Schwenkabschnitts einführbar sind, in eine Gebrauchslage schwenkbar ist. Die Aufgabe wird weiterhin gelöst durch ein Verfahren zur Herstellung einer erfindungsgemäßen elektrischen Vorrichtung mit den Merkmalen des Anspruchs 18.

Bei dem erfindungsgemäßen Verfahren zur Herstellung einer erfindungsgemäßen elektrischen Vorrichtung wird der Schaltungsträger in dem Gehäuse oder in oder an einem Gehäuseteil zur Bildung des Aufnahmeabschnitts angeordnet. Der Kontaktierungsabschnitt wird mit Kontaktelementen in dem Steckverbinderkörper des in seiner Verbindungslage angeordneten Schwenkabschnitts verbunden oder es werden an dem Kontaktierungsabschnitt bereits gehaltene Kontaktelemente in den Steckverbinderkörper des Schwenkabschnitts in der Verbindungslage eingeführt. Der Schwenkabschnitt wird dann in die Gebrauchslage geschwenkt.

Das erfindungsgemäße Gehäuse ist zur Verwendung mit einem Schaltungsträger vorgesehen, der wenigstens zwei mechanisch und elektrisch miteinander verbundene, relativ zueinander schwenkbare Abschnitte umfasst. Ein als Kontaktierungsabschnitt bezeichneter Abschnitt ist dabei zur Verbindung mit Kontaktelementen in dem Steckverbinderkörper ausgebildet oder kann bereits in den Steckverbinderkörper einzuführende Kontaktelemente umfassen. Er kann darüber hinaus auch noch weitere Bauteile einer auf dem Schaltungsträger ausgebildeten elektrischen oder elektronischen Schaltung aufweisen. Der zweite, als Schaltungsabschnitt bezeichnete Abschnitt ist mechanisch und elektrisch mit dem Kontaktierungsabschnitt verbunden und weist weitere Komponenten der elektrischen oder elektronischen Schaltung auf und braucht nicht zur Kontaktierung von Kontaktelementen eines Steckverbinders ausgebildet zu sein oder entsprechenden Kontaktelemente zu besitzen. Das Schwenken der Abschnitte zueinander kann beispielsweise durch ein Biegen des Schaltungsträgers zwischen Kontaktierungsabschnitt und Schaltungsabschnitt erfolgen, das grundsätzlich nur einmal möglich zu sein braucht.

Das erfindungsgemäße Gehäuse besitzt einen Aufnahmeabschnitt, der zur Aufnahme wenigstens des Schaltungsabschnitts des Schaltungsträgers dient. Der Aufnahmeabschnitt kann nach Schwenken des Schwenkabschnitts in die Gebrauchslage auch den Kontaktierungsabschnitt des Schaltungsträgers aufnehmen, jedoch braucht dies nicht unbedingt der Fall zu sein. Der Schaltungsträger braucht dementsprechend nicht vollständig in dem Gehäuse angeordnet zu sein, doch nimmt das Gehäuse bevorzugt den Schaltungsträger vollständig auf.

Weiterhin ist zur Herstellung einer Steckverbindung mit einem komplementären Steckverbinder der mit dem Gehäuse verbundene Schwenkabschnitt mit dem Steckverbinderkörper vorgesehen. Der Steckverbinderkörper dient zur Aufnahme von mit dem Kontaktierungsabschnitt elektrisch zu verbindenden oder verbundenen Kontaktelementen. Bei den Kontaktelementen kann es sich um beliebige weibliche und/oder männliche Kontaktelemente handeln, insbesondere können Buchsen und/oder Kontaktstifte bzw. -zungen oder -messer verwendet werden.

Weiterhin kann der Steckverbinderkörper als Führung für den komplementären Steckverbinder ausgebildet sein und dazu Führungseinrichtungen, wie beispielsweise einen um die Kontaktelemente umlaufenden Kragen oder auch Führungsnuten oder -leisten, aufweisen.

Der Schwenkabschnitt ist wenigstens zwischen einer Verbindungslage und einer Gebrauchslage schwenkbar an dem Aufnahmeabschnitt gehalten. In der Verbindungslage sind in dem Steckverbinderkörper gehaltene Kontaktelemente elektrisch mit dem Kontaktierungsabschnitt, insbesondere Kontaktflächen, Leiterbahnen oder ähnlichen Kontaktierungseinrichtungen auf diesem, verbindbar. Zur Verbindung können beispielsweise bekannte Verbindungsverfahren, beispielsweise Lötverfahren, Verwendung finden. Alternativ sind in der Verbindungslage an dem Kontaktierungsabschnitt bereits gehaltene, insbesondere mit Leiterbahnen auf diesem elektrisch verbundene, Kontaktelemente in den Steckverbinderkörper des Schwenkabschnitts einführbar.

Nach Herstellung einer Verbindung zu dem Kontaktierungsabschnitt bzw. dem Einführen von an dem Kontaktierungsabschnitt gehaltenen Kontaktelementen in den Steckverbinderkörper ist der Schwenkabschnitt dann in eine Gebrauchslage schwenkbar, in der er eine zu dem restlichen Gehäuse definierte, vorgegebene Lage einnimmt. Dabei nimmt der Schwenkabschnitt den Kontaktierungsabschnitt wenigstens teilweise mit, so dass auch dieser relativ zu dem Schaltungsabschnitt geschwenkt wird. In der Gebrauchslage kann der Kontaktierungsabschnitt eine Öffnung in dem Gehäuse oder dem Aufnahmeabschnitt wenigstens teilweise verschließen.

Zur Herstellung einer erfindungsgemäßen elektrischen Vorrichtung braucht also nur der Schaltungsträger mit dem Schaltungsabschnitt in dem Gehäuse bzw. in oder an einem Gehäuseteil zur Bildung des Aufnahmeabschnitts, beispielsweise in Verbindung mit anderen Gehäuseteilen, angeordnet, der Kontaktierungsabschnitt mit Kontaktelementen in dem Steckverbinderkörper des in seiner Verbindungslage angeordneten Schwenkabschnitts verbunden und der Schwenkabschnitt dann in die Gebrauchslage geschwenkt zu werden. Bei Verwendung eines Schaltungsträgers, bei dem die Kontaktelemente bereits mit dem Kontaktierungsabschnitt verbunden sind, brauchen diese nur vor, während oder nach dem Anordnen des Schaltungsabschnitts in dem Gehäuse oder Gehäuseteil in den Steckverbinderkörper, vorzugsweise darin bereits ausgebildete Kanälen darin, eingeführt zu werden. Der Schwenkäbschnitt kann dann in die Gebrauchslage geschwenkt werden.

Auf diese Weise kann ein Verbinden zwischen dem Kontaktierungsab-schnitt des Schaltungsträgers mit Kontaktelementen in dem Steckverbinderkörper bzw. ein Einführen von an dem Kontaktierungsabschnitt bereits gehaltenen Kontaktelementen in den Steckverbinderkörper in einer dazu jeweils vorteilhaften Lage erfolgen, wobei jedoch die durch den Steckverbinderkörper in der Gebrauchslage bestimmte Steckrichtung relativ zu dem Gehäuse und insbesondere einer Ebene des darin aufgenommenen Schaltungsabschnitts durch entsprechende Auslegung des Gehäuses und des Schwenkabschnitts abweichend von der Steckrichtung in der Verbindungslage vorgegeben werden kann.

Darüber hinaus ist der Steckverbinderkörper in das erfindungsgemäße Gehäuse integriert, so dass die Handhabung einer separaten Geräteaufnahme entfallen kann. Hierdurch können insbesondere Arbeitsschritte bei der Herstellung der erfindungsgemäßen elektrischen Vorrichtung gegenüber einem Herstellverfahren mit einer separaten Geräteaufnahme eingespart werden.

Weiterbildungen und bevorzugte Ausführungsformen der Erfindung sind in den Ansprüchen, der Beschreibung und den Zeichnungen beschrieben.

Grundsätzlich kann der Schwenkabschnitt in beliebiger Art und Weise mit dem Aufnahmeabschnitt verbunden sein. Insbesondere kann er nur indirekt an diesem befestigt sein. Es ist jedoch bevorzugt, dass der Schwenkabschnitt einstückig mit dem Aufnahmeabschnitt ausgebildet und über ein Filmgelenk verbunden ist. Die einstückige Ausbildung des Schwenkabschnitts mit dem Aufnahmeabschnitt erlaubt eine besonders einfache Herstellung des Gehäuses, beispielsweise bei Ausführung des Gehäuses als Kunststoff-Spritzguss-Teil. Eine komplizierte Herstellung einer Schwenkverbindung kann entfallen. Unter einem Filmgelenk wird dabei ein Bereich in einer Wand eines den Schwenkabschnitt umfassenden Gehäuseteils verstanden, dessen Dicke so stark reduziert ist, dass der Schwenkabschnitt gegenüber dem Rest des Gehäuseteils ohne Bruch des in seiner Dicke reduzierten Bereichs schwenkbar ist.

Besonders bevorzugt ist der Schwenkabschnitt dabei über das Filmgelenk mit einem Halteabschnitt des Gehäuses verbunden, mittels dessen der Schaltungsabschnitt in dem Gehäuse haltbar ist. Der Schaltungsabschnitt kann dann vor der Kontaktierung bzw. vor dem Einführen von an dem Kontaktierungsabschnitt gehaltenen Kontaktelementen bereits in oder an dem Halteabschnitt gehalten sein, was die Kontaktierung bzw. das Einführen der an dem Kontaktierungsabschnitt gehaltenen Kontaktelemente vereinfacht.

Dabei ist es bevorzugt, dass sich die Flanken des Filmgelenks und/oder die dem Filmgelenk unmittelbar benachbarten Bereiche des Gehäuses in der Gebrauchslage aufeinander abstützen. Auf diese Weise können die Flanken des Filmgelenks bzw. die unmittelbar benachbarten Bereiche des Gehäuses in der Gebrauchslage Kräfte aufnehmen, die beispielsweise bei Herstellung einer Steckverbindung mit einem komplementären Steckverbinder auftreten können.

Der Aufnahmeabschnitt kann grundsätzlich beliebig ausgebildet sein und braucht insbesondere den Schaltungsabschnitt nicht vollständig zu umschließen. Bei einer Ausführungsform des erfindungsgemäßen Gehäuses ist es bevorzugt, dass der Aufnahmeabschnitt einstückig und wenigstens teilweise hülsen- oder taschenförmig mit wenigstens einer Öffnung ausgebildet ist und dass die Öffnung durch Schwenken des Schwenkabschnitts aus der Verbindungslage in die Gebrauchslage wenigstens teilweise verschließbar ist. Vorzugsweise ist die Öffnung in dem Aufnahmeabschnitt in der Gebrauchslage vollständig verschlossen. Solche Gehäuse mit einstückigen Aufnahmeabschnitten, die hülsen- oder taschenförmig gestaltet sein können, erlauben eine besonders gute Abdichtung des umschlossenen Innenraums, da umlaufende Verbindungen zwischen separaten Gehäuseteilen weitgehend vermieden werden können.

Besonders bevorzugt ist der Aufnahmeabschnitt hülsenförmig ausgebildet und weist an beiden Enden jeweils eine Öffnung auf, wobei jede der Öffnungen durch Schwenken eines entsprechenden Schwenkabschnitts aus einer Verbindungslage in eine Gebrauchslage wenigstens teilweise, vorzugsweise ganz verschließbar ist. Auf diese Weise können beispielsweise in einem Kabelbaum anzuordnende elektrische Vorrichtungen einfach mit Eingangs- und Ausgangs-Leitungen verbunden werden, wobei durch geeignete Festlegung der Orientierung der jeweiligen Gebrauchslagen der Schwenkabschnitte die durch die Steckverbinderkörper definierten Steckrichtungen wählbar sind. Insbesondere können beide Steckrichtungen parallel zu einer Ebene des Schaltungsabschnitts verlaufen.

Alternativ ist es bevorzugt, dass das Gehäuse wenigstens zwei getrennte Gehäuseteile aufweist, die zusammengefügt den Aufnahmeabschnitt bilden. Die Gehäuseteile können weitere Bereiche aufweisen, die nicht den Aufnahmeabschnitt bilden, insbesondere kann eines der Gehäuseteile einstückig mit dem Schwenkabschnitt ausgebildet sein. Solche Gehäuse mit zwei separaten Gehäuseteilen können das Einsetzen des Schaltungsabschnitts erleichtern. Dies ist insbesondere dann der Fall, wenn eines der Gehäuseteile als Halteabschnitt fungiert und an diesem auch der Schwenkabschnitt gehalten ist.

Bei einer anderen Ausführungsform ist es bevorzugt, dass das Gehäuse zwei schwenkbar miteinander verbundene, aufeinander schwenkbare Gehäuseteile aufweist, die in eine Gehäuseendlage schwenkbar sind, in der sie zusammengefügt den Aufnahmeabschnitt bilden. Insbesondere bei Herstellung des Gehäuses aus Kunststoff in Spritzgusstechnik kann so das Gehäuse insgesamt einstückig ausgebildet werden, wobei dann die Gehäuseteile wiederum über ein Filmgelenk miteinander verbunden sind. Die Herstellung wie auch die Handhabung eines solchen Gehäuses wird durch die einteilige Ausbildung erheblich vereinfacht. Insbesondere kann nach Anordnung des Schaltungsabschnitts des Schaltungsträgers in oder an einem der Gehäuseteile und Verbindung des Kontaktierungsabschnitts mit in dem Steckverbinderkörper gehaltenen Kontaktelementen bzw. Einführen von an dem Kontaktierungsabschnitt gehaltenen Kontaktelementen der Schwenkabschnitt relativ zu dem mit diesem verbundenen Gehäuseteil in die Gebrauchslage geschwenkt und das Gehäuseteil relativ zu dem anderen Gehäuseteil unter Bildung des Aufnahmeabschnitts in die Gehäuseendlage geschwenkt werden, so dass die Positionierung eines zweiten Gehäuseteils entfallen kann.

Grundsätzlich genügt es bei einer Ausführungsform dabei, dass der Schwenkabschnitt mit nur einem der beiden Gehäuseteile verbunden ist. Bei einer Ausführungsform des erfindungsgemäßen Gehäuses ist es jedoch bevorzugt, dass die beiden Gehäuseteile über Filmgelenke mit dem Schwenkabschnitt verbunden sind. Auf diese Weise kann die Gesamtlänge von Gehäusenähten in dem zusammengefügten Gehäuses minimiert werden, da Gehäusenähte zwischen dem Schwenkabschnitt und den Gehäuseteilen entfallen.

Bei einem wenigstens zweiteiligen Gehäuse oder einem Gehäuse mit schwenkbar miteinander verbundenen Gehäuseteilen ist es bevorzugt, dass eines bzw. einer der Gehäuseteile so ausgebildet ist, dass der Schaltungsabschnitt auf einer Lötseite zugänglich ist, wenn der Schaltungsabschnitt in bzw. an dem Gehäuseteil gehalten ist und die Gehäuseteile nicht zusammengefügt sind. Unter der Lötseite wird dabei die Seite des Schaltungsabschnitts verstanden, die zur Herstellung einer Lötverbindung auf bzw. in dem Schaltungsabschnitt zugänglich sein muss. Auf diese Weise ist es grundsätzlich möglich, bei einem geeigneten Lötverfahren den Schaltungsträger erst nach Einsetzen in bzw. Aufsetzen auf das bzw. den Gehäuseteil oder Halteabschnitt wenigstens teilweise zu bestücken bzw. die Lötverbindungen zu erstellen.

Um eine besonders einfache Herstellung wenigstens eines mit dem Schwenkabschnitt verbundenen Gehäuseteils zu ermöglichen, ist es bevorzugt, dass der bzw. das mit dem Schwenkabschnitt verbundene Gehäuseteil in einer Herstellungslage des Schwenkabschnitts in einer durch den Steckverbinderkörper gegebenen Steckrichtung keine Hinterschneidungen aufweist. Auf diese Weise kann der bzw. das Gehäuseteil mit dem Schwenkabschnitt einfach mit einem zweiteiligen Spritzgusswerkzeug, insbesondere keine Schieber oder ähnliche Einrichtungen aufzuweisen braucht, hergestellt werden, so dass die Zykluszeiten bei der Herstellung des Gehäuseteils sehr gering gehalten werden können und das Spritzgusswerkzeug sehr einfach zu fertigen ist. Die Herstellungslage kann dabei vorzugsweise mit der Verbindungslage übereinstimmen, jedoch braucht dies nicht der Fall zu sein.

Um eine Verbindung mit dem Kontaktierungsabschnitt zu erleichtern, ist es bevorzugt, dass in dem Steckverbinderkörper Kontaktelemente mit Kontaktierungsenden zur Verbindung mit dem Kontaktierungsabschnitt des Schaltungsträgers angeordnet sind, und dass in der Verbindungslage die Kontaktierungsenden im Wesentlichen orthogonal zu einer Ebene verlaufen, die durch den Schaltungsabschnitt des in dem Gehäuse oder einem Teil desselben gehaltenen Schaltungsträgers bestimmt ist. Auf diese Weise können die Kontaktierungsenden besonders einfach durch entsprechende Öffnungen in dem Kontaktierungsabschnitt des Schaltungsträgers geführt werden, wobei dieser gestreckt angeordnet ist. Sowohl das Einsetzen des Schaltungsträgers in bzw. das Aufsetzen auf ein entsprechendes Gehäuseteil bzw. einen Halteabschnitt als auch die nachfolgende Kontaktierung kann dann in der gleichen Montagerichtung erfolgen, was die Verwendung einer besonders einfache Fertigungseinrichtung erlaubt.

Weiterhin ist es bevorzugt, dass der Steckverbinderkörper im Wesentlichen linear und parallel zu einer durch den Steckverbinderkörper bestimmten Steckrichtung verlaufende Kanäle zur Aufnahme von Kontaktelementen aufweist. Die Kanäle können dabei schon vor einer Bestückung mit Kontaktelementen ausgebildet sein, so dass diese nur in die Kanäle eingeschoben zu werden brauchen. Es ist jedoch auch möglich, dass die Kanäle durch Umspritzen von Kontaktelementen beim Spritzguss des Steckverbinderkörpers gebildet werden. Weiterhin ist es möglich, dass diese Kanäle erst nach Verbindung des Steckverbinderkörpers durch Einpressen von linearen Kontaktelementen, beispielsweise Stiften gebildet werden. Diese Anordnung der Kanäle erlaubt nicht nur eine hinterschneidungsfreie Form des mit dem Schwenkabschnitt verbundenen Gehäuseteils, sondern auch eine besonders einfache Ausbildung der Kontaktelemente.

Um ein Einführen von an dem Kontaktierungsabschnitt gehaltenen Kontaktelementen in den Steckverbinderkörper des Schwenkabschnitts in der Verbindungslage zu erleichtern, ist es bevorzugt, dass die Kanäle im Wesentlichen orthogonal zu einer Ebene verlaufen, die durch den Schaltungsabschnitt des in dem Gehäuse oder einem Teil desselben gehaltenen Schaltungsträgers bestimmt ist. Auf diese Weise können die Kontaktelemente besonders einfach in die Kanäle in dem Steckverbinderkörper eingeführt geführt werden, wobei der Schaltungsträger insbesondere gestreckt angeordnet sein kann. Sowohl das Einsetzen des Schaltungsträgers in bzw. das Aufsetzen auf ein entsprechendes Gehäuseteil bzw. einen Halteabschnitt als auch das nachfolgende Einführen der Kontaktelemente kann dann in der gleichen Montagerichtung erfolgen, was die Verwendung einer besonders einfache Fertigungseinrichtung erlaubt.

Grundsätzlich kann eine durch den Steckverbinderkörper bestimmte Steckrichtung in der Endlage einen beliebigen Winkel mit einer durch den Aufnahmeabschnitt bzw. den Schaltungsabschnitt des Schaltungsträgers definierten Ebene einschließen. Häufig sind jedoch die Schaltungsabschnitte flächig ausgebildet, so dass für eine raumsparende Ausbildung auch das Gehäuse flach ausgebildet ist. Es ist daher bevorzugt, dass in der Gebrauchslage eine durch den Steckverbinderkörper bestimmte Steckrichtung im Wesentlichen parallel zu einer durch den Schaltungsabschnitt des in dem Gehäuse gehaltenen Schaltungsträgers bestimmten Ebene orientiert ist. Auf diese Weise kann die Steckrichtung parallel zu der vergleichsweise kleinen Stirnfläche eines solchen Gehäuses verlaufen, so dass auch nach Verbindung mit einem komplementären Steckverbinder eine sehr raumsparende Anordnung ermöglicht wird.

Um ein Zurückschwenken des Schwenkabschnitts aus der Gebrauchslage zu vermeiden, können grundsätzlich Sicherungsmittel an dem Schaltungsträger und dem Schwenkabschnitt vorgesehen sein, mittels dessen der Schwenkabschnitt oder der Kontaktierungsabschnitt relativ zu dem Schaltungsträger, insbesondere dessen Schaltungsabschnitt in der Gebrauchslage sicherbar ist. Es ist jedoch bevorzugt, dass das Gehäuse Sicherungsmittel zur Sicherung des Schwenkabschnitts in der Gebrauchslage aufweist. Hierbei können insbesondere Schnapp- oder Rastverbindungen und/oder Klemmverbindungen verwendet werden, die eine werkzeugfreie Sicherung des Schwenkabschnitts in der Gebrauchslage erlauben. Weiterhin können Elemente für Schraubverbindungen, Durchgangslöcher und damit fluchtende Gewindeaufnahmen vorgesehen sein. Die Sicherungseinrichtung kann dabei je nach Art des Gehäuses unterschiedlich ausgebildet sein. Ist der Schwenkabschnitt über nur ein Filmgelenk mit einem entsprechenden Gehäuseteil verbunden, so weist vorzugsweise der Schwenkabschnitt und ein weiteres Gehäuseteil Sicherungselemente auf, durch deren Zusammenwirken der Schwenkabschnitt relativ zu dem restlichen Gehäuse in der Gebrauchslage sicherbar ist. Ist der Schwenkabschnitt dagegen über zwei Filmgelenke mit zwei Gehäuseteilen verbunden, so kann die Sicherungseinrichtung auch an den beiden Gehäuseteilen vorgesehen sein, da in diesem Fall durch das Zusammenfügen dieser Gehäuseteile und deren Sicherung in der Gehäuseendlage die Lage des Schwenkabschnitts relativ zu den beiden Gehäuseteilen festliegt.

Weiterhin ist es bevorzugt, dass an dem Gehäuse ein Anschlag vorgesehen ist, gegen den sich der Schwenkabschnitt in seiner Gebrauchslage abstützt, wenn auf dieses durch Zusammenstecken mit einem komplementären Steckverbinder Kräfte entgegen der Steckrichtung ausgeübt werden. Auf diese Weise kann das Gehäuse auch große auftretende Steckkräfte einfach aufnehmen, ohne dass eine Beschädigung des Filmgelenks zu befürchten wäre.

Die Schaltungsträger der erfindungsgemäßen elektrischen Vorrichtung können grundsätzlich beliebig ausgebildet sein. Bei einer bevorzugten Ausführungsform der erfindungsgemäßen elektrischen Vorrichtung ist es vorgesehen, dass der Schaltungsträger wenigstens eine flexible Trägerfolie, insbesondere für Leiterbahnen, umfasst. Insbesondere kann der Schaltungsträger Teil einer flexiblen gedruckten Schaltung, insbesondere in Form von FPC (Flexible Printed Circuit), sein. Solche Schaltungsträger bzw. Schaltungen sind sehr einfach herstellbar, wobei sich automatisch ein Kontaktierungsabschnitt ergibt, der gegenüber einem Schaltungsabschnitt schwenkbar ist.

Dabei ist es besonders bevorzugt, dass der Kontaktierungsabschnitt und/oder der Schaltungsabschnitt mechanisch verstärkt sind. Auf diese Weise kann selbst bei einem Schwenken des Kontaktierungsabschnitts gegenüber dem Schaltungsabschnitt um einen großen Winkel eine starke mechanische Belastung der flexiblen Schaltung in zu der Biegestelle benachbarten Bereichen aufgefangen werden.

Alternativ ist es bevorzugt, dass der Kontaktierungsabschnitt und/oder der Schaltungsabschnitt eine im Wesentlichen starre Platine aufweisen und dass der Kontaktierungsabschnitt und der Schaltungsabschnitt durch einen flexiblen Flachleiter oder eine flexible gedruckte Schaltung elektrisch und mechanisch miteinander verbunden sind. Unter flexiblen Flachleitern werden insbesondere auch FFC (Flexible Flat Cable bzw. Circuit) verstanden.

Schließlich ist es bei Verwendung eines geeigneten starren Schaltungsträgers auch möglich, diesen zur Ausbildung einer Knicklinie entlang dieser Linie teilweise auszufräsen, so dass ein Abknicken ermöglicht wird. Beispielsweise können hierzu Platinen aus faserverstärkten Werkstoffen verwendet werden.

Es ist jedoch auch denkbar, dass der Steckverbinderkörper und der Schaltungsträger integriert sind. Gegenstand der Erfindung ist daher auch ein Schaltungsträger mit einem Schaltungsabschnitt, einem mit dem Schaltungsabschnitt mechanisch und elektrisch verbundenen, gegenüber dem Schaltungsabschnitt schwenkbaren Kontaktierungsabschnitt und einem mit dem Kontaktierungsabschnitt einstückig ausgebildeten Steckverbinderkörper zur Aufnahme von mit dem Kontaktierungsabschnitt elektrisch zu verbindenden Kontaktelementen, wobei der Kontaktierungsabschnitt aus einer Verbindungslage, in der der Kontaktierungsabschnitt elektrisch mit in dem Steckverbinderkörper gehaltenen Kontaktelementen verbindbar ist, in eine Gebrauchslage schwenkbar ist. Der Schaltungsträger kann insbesondere in MID-Technik erstellt sein. In Bezug auf den Schaltungsabschnitt und den Kontaktierungsabschnitt sowie die Kontaktierungs- und Gebrauchslage gelten die Ausführungen im Zusammenhang mit dem erfindungsgemäßen Gehäuse entsprechend. Weiterhin können der Steckverbinderkörper und dessen Befestigung an dem Schaltungsabschnitt entsprechend den zuvor genannten Weiterbildungen ausgebildet sein.

Dabei ist es besonders bevorzugt, dass der Schaltungsträger einen Teil eines Gehäuses einer elektrischen Vorrichtung bildet, die darüber hinaus noch wenigstens einen weiteren getrennten Gehäuseteil oder ein einstückig mit dem Schaltungsträger ausgebildetes Gehäuseteil aufweisen kann.

In vielen Situationen, beispielsweise im Automobilbau, steht zur Herstellung einer Steckverbindung nur sehr wenig Raum zur Verfügung. Es ist daher bei dem erfindungsgemäßen Verfahren bevorzugt, dass vor einem Schwenken des Schwenkabschnitts in die Gebrauchslage ein komplementärer Steckverbinder mit dem Steckverbinderkörper des erfindungsgemäßen Gehäuses zusammengesteckt wird. Auf diese Weise kann beim Einbau einer erfindungsgemäßen elektrischen Vorrichtung beispielsweise in ein Fahrzeug zunächst das Gehäuse eingebaut werden, wobei der Schwenkabschnitt in eine für ein Zusammenstecken mit dem komplementären Steckverbinder günstige Lage geschwenkt werden kann. Erst nach Herstellung der Steckverbindung wird dieses dann in die Gebrauchslage geschwenkt und dort ggf. gesichert. Das Herstellen der Steckverbindung kann dadurch stark vereinfacht werden. Diese Weiterbildung des erfindungsgemäßen Verfahrens kann daher auch als Verfahren zur Verbindung eines Schaltungsträgers mit einer Leitung angesehen werden.

Erfindungsgemäße Gehäuse und elektrische Vorrichtungen können bevorzugt im Automobilbau verwendet werden.

Die Erfindung wird nun beispielhaft unter Bezugnahme auf die Zeichnungen weiter erläutert. Es zeigen.
- Fig. 1: eine schematische seitliche Schnittansicht einer elektrischen Vorrichtung mit einem Gehäuse nach einer ersten bevorzugten Ausführungsform der Erfindung, bei der ein Schwenkabschnitt eine Verbindungslage einnimmt,
- Fig. 2: die schematische seitliche Schnittansicht der elektrischen Vorrichtung in Fig. 1, wobei der Schwenkabschnitt nun seine Gebrauchslage einnimmt, und
- Fig. 3: eine schematische seitliche Schnittansicht einer elektrischen Vorrichtung mit einem aufgeklappten Gehäuse nach einer dritten bevorzugten Ausführungsform der Erfindung in einer Verbindungslage.

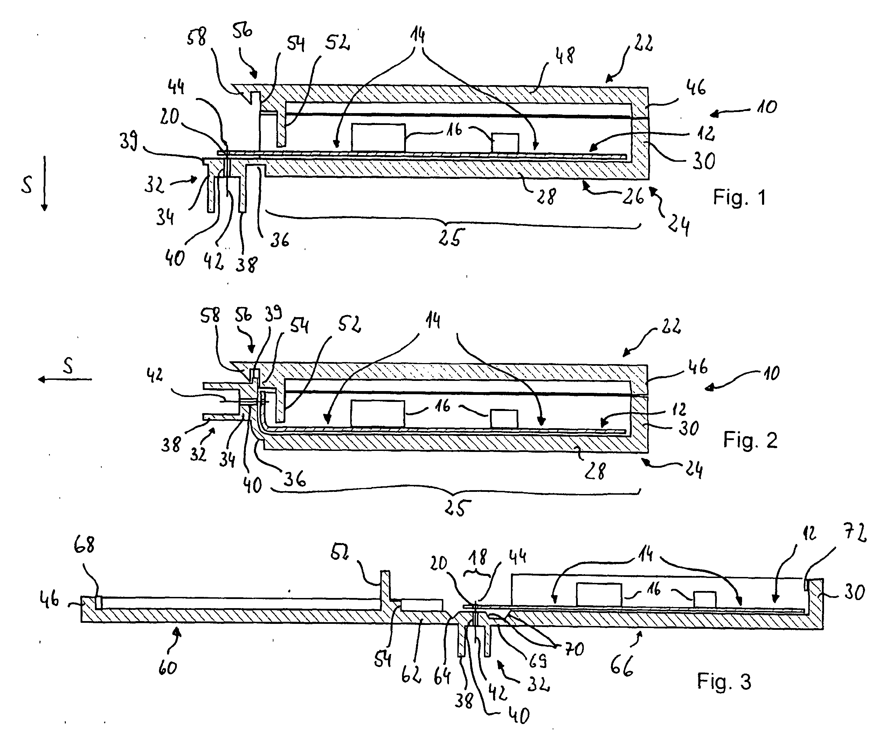

In den Fig. 1 und 2 umfasst eine elektrische Vorrichtung nach einer ersten bevorzugten Ausführungsform der Erfindung ein Gehäuse 10 nach einer ersten bevorzugten Ausführungsform der Erfindung und einen darin aufgenommenen Schaltungsträger 12. Der Schaltungsträger 12 ist als FPC (Flexible Printed Circuit) ausgebildet und weist einen flächigen Schaltungsabschnitt 14 mit darauf angeordneten elektrischen und/oder elektronischen Bauelementen 16 sowie einen relativ zu dem Schaltungsabschnitt 14 schwenkbaren Kontaktierungsabschnitt 18 mit Kontaktierungsöffnungen 20 auf.

Das Gehäuse 10 besitzt ein Gehäuseoberteil 22 und ein Gehäuseunterteil 24, die unter Ausbildung eines Aufnahmeabschnitts 25 zusammenfügbar sind. Es ist entsprechend der flächigen Ausdehnung des Schaltungsabschnitts 14 ebenfalls flach ausgebildet.

Das Gehäuseunterteil 24 weist einen Halteabschnitt 26 zur wenigstens teilweisen Aufnahme und Halterung des Schaltungsabschnitts 14 des Schaltungsträgers 12 auf. Der Halteabschnitt 26 umfasst einen Boden 28 und eine darauf angeordnete U-förmige Wand 30. Der Halteabschnitt 26 verfügt weiterhin, in den Figuren nicht gezeigt, über Positionier- und Befestigungselemente zur Befestigung des Schaltungsträgers 12 mit seinem Schaltungsabschnitt 14 in bzw. an dem Halteabschnitt 26.

Weiterhin besitzt das Gehäuseunterteil 24 einen Schwenkabschnitt 32 mit einem Steckverbinderkörper 34, der über ein Filmgelenk 36 mit dem Halteabschnitt 26 und damit dem Gehäuseunterteil 24 sowie dem damit gebildeten Aufnahmeabschnitt 25 relativ zu diesem schwenkbar verbunden ist.

Der Steckverbinderkörper 34 des Schwenkabschnitts 32 ist als Aufnahme für einen komplementären Steckverbinder ausgebildet und besitzt dazu einen Führungskragen 38. An einer dem Halteabschnitt 26 abgewandten Seite weist der Schwenkabschnitt 32 bzw. der Steckverbinderkörper 34 an einer dem Schaltungsträger zugewandten Kante eine Rastleiste 39 als Sicherungselement auf.

In dem Steckverbinderkörper 34 sind weiterhin parallel zu einer durch den Kragen 38 vorgegebenen Steckrichtung S verlaufende Kanäle 40 für im Wesentlichen lineare Kontaktelemente 42, im Beispiel Kontaktstifte, ausgebildet. Kontaktierungsenden 44 der Kontaktelemente 42 ragen dabei auf der dem Kragen 38 abgewandten Seite des Steckverbinderkörpers 34 entgegen der Steckrichtung S aus den Kanälen 40 heraus.

Die Kanäle 40 und die Kontaktierungsöffnungen 20 sind so ausgebildet, dass diese in der in Fig. 1 gezeigten Verbindungslage des Schwenkabschnitts 32 miteinander fluchten.

Das Gehäuseoberteil 22 besitzt eine dem Gehäuseunterteil 24 entsprechende Form und umfasst insbesondere ebenfalls eine der U-förmigen Wand 30 entsprechende U-förmige Wand 46, die durch einen Deckelabschnitt 48 abgedeckt ist.

Die Öffnung der U-förmigen Wand 46 ist teilweise durch eine Trennwand 52 mit einem Anschlag 54 verschlossen. Die Trennwand 52 ist dabei so hoch, dass bei einem Zusammensetzen des Gehäuseoberteils 22 und des Gehäuseunterteils 24 der Schaltungsträger 12 nicht zwischen der Trennwand 52 und dem Boden 28 des Gehäuseunterteils 24 festgeklemmt wird.

Der Deckelabschnitt 48 setzt sich über den Anschlag 54 hinaus in ein nur sehr schematisch gezeigtes Sicherungselement 56 in Form eines Rastarms mit einem Rasthaken 58 fort, die zur Wechselwirkung mit der Rastleiste 39 ausgebildet ist.

Weiterhin sind an dem Gehäuseoberteil 22 und dem Gehäuseunterteil 24 in den Figuren nicht gezeigte Verbindungseinrichtungen vorgesehen, mittels derer die Gehäuseteile unter Bildung des Aufnahmeabschnitts 25 miteinander verbindbar sind.

Sowohl das Gehäuseoberteil 22 als auch das Gehäuseunterteil 24, bei dem der Schwenkabschnitt 32 in der in Fig. 1 gezeigten Verbindungslage relativ zu dem Aufnahmeabschnitt 25 angeordnet ist, weisen in der orthogonal zu der Fläche des Schaltungsabschnitts 14 bzw. parallel zu der durch den Steckverbinderkörper 34 definierten Steckrichtung S keine Hinterschneidungen auf, so dass diese Teile für sich genommen jeweils einstückig einfach mittels eines zweiteiligen Spritzgusswerkzeugs ohne Schieber aus einem geeigneten Kunststoff durch Spritzguss herstellbar sind.

Zur Herstellung der elektrischen Vorrichtung werden zunächst das Gehäuseoberteil 22 und das Gehäuseunterteil 24 durch Spritzguss hergestellt. Bei dem Gehäuseunterteil 24 nimmt dabei der Schwenkabschnitt 32 die in Fig. 1 gezeigte Herstellungslage ein.

Danach werden die Kontaktelemente 42 in die so gebildeten Kanäle 40 eingepresst. Hierbei kann die Bestückung parallel zu der gleichen Richtung erfolgen, in der die Spritzgusswerkzeuge bewegt werden. Bei anderen Ausführungsformen können diese auch beim Spritzguss unmittelbar in den Steckverbinderkörper 34 eingespritzt werden.

Sodann wird der Schaltungsträger 12 mit dem Schaltungsabschnitt 14 in dem Gehäuseunterteil 24, insbesondere dem Halteabschnitt 26 angeordnet, wobei der Kontaktierungsabschnitt 18 auf dem Schwenkabschnitt 32 zu liegen kommt, so dass die Kanäle 40 und die Kontaktierungsöffnung 20 miteinander fluchten.

In der in Fig. 1 gezeigten Verbindungslage sind die Kontaktierungsenden 44 der Kontaktelemente 42 parallel zu der Steckrichtung S und damit im Wesentlichen orthogonal zu einer durch den Schaltungsabschnitt 14 definierten Ebene ausgerichtet, so dass die Kontaktierungsenden 44 in den Kanälen 40 durch die Kontaktierungsöffnungen 20 geführt werden können. Diese können nun mit entsprechenden, in den Figuren nicht gezeigten Leiterbahnen des Kontaktierungsabschnitts 18 elektrisch, beispielsweise durch Löten verbunden werden, da der entsprechende Bereich für diesen Vorgang frei zugänglich ist.

In einem folgenden Schritt wird das Gehäuseoberteil 22 auf das Gehäuseunterteil 24 mit dem darin angeordneten Schaltungsträger 12 gesetzt und mit dem Gehäuseunterteil 24 verbunden. Dabei wird der Aufnahmeabschnitt 25 gebildet.

Nun kann der Schwenkabschnitt 32 um etwa 90° in die in Fig. 2 gezeigte Gebrauchslage geschwenkt werden, in der die durch den Steckverbinderkörper 34 bzw. dessen Kragen 38 gegebene Steckrichtung S parallel zu der durch den Schaltungsabschnitt 14 definierten Ebene verläuft. Dabei wird der Kontaktierungsabschnitt 18 des Schaltungsträgers 12 gegenüber dem Schaltungsabschnitt 14 aufgebogen. Weiterhin stößt der Schwenkabschnitt 32 bzw. der Steckverbinderkörper 34 in der Gebrauchslage an den Anschlag 54 an, so dass auf den Steckverbinderkörper 34 wirkende Kräfte parallel zur Steckrichtung durch den Anschlag 54 bzw. das Filmgelenk 36 aufgenommen und an das Gehäuseoberteil 22 bzw. das Gehäuseunterteil 24 weitergeleitet werden können.

In der Gebrauchslage ist weiterhin die Rastleiste 39 hinter dem Rasthaken 58 des Sicherungselements 56 eingerastet und hält den Schwenkabschnitt 32 so in seiner Gebrauchslage. Die Rastleiste 39 und das Sicherungselement 56 bilden somit eine Sicherungseinrichtung im Sinne der Erfindung.

Soll die beschriebene elektrische Vorrichtung an einem für die Herstellung einer Steckverbindung ungünstigen Stelle angebracht werden, kann das Umschwenken des Schwenkabschnitts 32 erst nach Herstellen einer Steckverbindung mit einem komplementären Steckverbinder erfolgen.

Eine elektrische Vorrichtung nach einer zweiten bevorzugten Ausführungsform der Erfindung unterscheidet sich von der elektrischen Vorrichtung des ersten Ausführungsbeispiels durch die Verbindung des Gehäuseoberteils 22 und des Gehäuseunterteils 24. In diesem Fall sind keine Verbindungseinrichtungen vorgesehen, sondern das Gehäuseoberteil 22 und das Gehäuseunterteil 24 sind an ihrem dem Schwenkabschnitt abgewandten Ende über ein Filmscharnier verbunden, so dass ein einstückig ausgebildetes Gehäuse mit zwei durch ein Filmgelenk verbundenen Gehäuseteilen entsteht. Auf diese Weise können das Gehäuseoberteil 22 und das Gehäuseunterteil 24 bei Herstellung mit einem Spritzgussverfahren einstückig in einem Verfahrensschritt gebildet werden. Zur Bildung des geschlossenen Gehäuses, bei dem die zusammengefügten Gehäuseteile den Aufnahmeabschnitt bilden, brauchen die Gehäuseteile nur aufeinander geklappt zu werden, was vor, gleichzeitig mit oder nach dem Schwenken des Schwenkabschnitts aus der Verbindungslage in die Gebrauchslage erfolgen kann.

Eine elektrische Vorrichtung nach einer dritten bevorzugten Ausführungsform der Erfindung unterscheidet sich von der elektrischen Vorrichtung des ersten Ausführungsbeispiels durch die Ausbildung und Verbindung des Gehäuseoberteils und des Gehäuseunterteils. Für gleiche bzw. sich entsprechende Elemente des Gehäuses werden die gleichen Bezugszeichen wie in dem ersten Ausführungsbeispiel verwendet und es gelten die Erläuterungen entsprechend.

Das Gehäuseoberteil 60 unterscheidet sich von dem Gehäuseoberteil 22 dadurch, dass statt des Sicherungselements 56 ein Streifen 62 vorgesehen ist, der über ein Filmgelenk 64 mit dem Gehäuseunterteil 66 verbunden ist. Weiterhin ist an dem Querabschnitt der U-förmigen Wand 46 ein erstes Sicherungselement 68 einer nur ganz schematisch gezeigten Sicherungseinrichtung vorgesehen. Die U-förmige Wand 46 erstreckt sich nun bis zum Filmgelenk 64.

Das Gehäuseunterteil 66 unterscheidet sich von dem Gehäuseunterteil 24 zum einen in der Ausbildung des Filmgelenks 69, das dem Filmgelenk 36 entspricht. Das Filmgelenk 69 weist nun in Richtung des Gehäuseinneren weisende in einem Winkel von 45° zu dem Boden 28 ausgebildete Flanken 70 auf, die bei einem Schwenken des Schwenkabschnitts 32 um 90° aneinander anstoßen und so Kräfte zwischen dem Schwenkabschnitt 32 und dem Boden 28 übertragen können.

Weiterhin ist die U-förmige Wand 30 ähnlich der U-förmigen Wand 46 bei dem Gehäuseoberteil 60 nun bis zu dem Filmgelenk 69 geführt.

An dem Querabschnitt der U-förmigen Wand 30 ist weiterhin ein zweites zu dem ersten Sicherungselement 68 komplementäres Sicherungselement 72 vorgesehen.

Das Filmgelenk 64 weist, wie das Filmgelenk 68 zwei einen Winkel von 90° miteinander und einen Winkel von 45° mit einer Ebene des Gehäuseoberteils 60 bildende Flanken auf, die bei Schwenken des Gehäuseoberteils 60 um einen Winkel von 90° gegenüber dem Schwenkabschnitt 32 aufeinander zu liegen kommen und so auf den Schwenkabschnitt 32 wirkende Kräfte auf das Gehäuseoberteil 60 übertragen können.

Die in Fig. 3 gezeigte Verbindungslage des Schwenkabschnitts 32 entspricht der Verbindungslage des Schwenkabschnitts 32 im ersten Ausführungsbeispiel, so dass die Montage des Schaltungsträgers 12 in der in Fig. 3 gezeigten Verbindungslage analog zu dem ersten Ausführungsbeispiel erfolgen kann.

Zum Schließen des Gehäuses braucht nun nur das Gehäuseoberteil 60 auf das Gehäuseunterteil 66 geklappt zu werden, wobei unter Abbiegen des Schaltungsträgers 12 der Schwenkabschnitt 32 mit seiner Steckrichtung S um 90° in eine Gebrauchslage geschwenkt wird, in der die Steckrichtung parallel zu der durch den Schaltungsabschnitt 14 definierten Ebene orientiert ist.

Beim Erreichen der Gebrauchslage des Schwenkabschnitts 32 erreichen das Gehäuseoberteil 60 und das Gehäuseunterteil 66 ihre Gehäuseendlage, bei der die U-förmigen Wände 30 und 46 aufeinander zu liegen kommen und die ersten und zweiten Sicherungselemente 68 und 72 zusammenwirken, um das Gehäuseoberteil 60 und das Gehäuseunterteil 66 in ihrer Gehäuseendlage zu sichern.

Bei weiteren Ausführungsbeispielen sind als Unterschied zu den vorhergehenden Ausführungsbeispielen die Kontaktelemente 42 vor Aufsetzen des Schaltungsträgers 12 auf den jeweiligen Halteabschnitt nicht in den Kanälen 40 angeordnet, sondern bereits an dem Kontaktierungsabschnitt 18 des Schaltungsträgers 12 gehalten, wozu sie beispielsweise durch entsprechende Löcher darin geführt und durch Löten mit Leiterbahnen auf dem Kontaktierungsabschnitt verbunden sein können. Dabei bilden deren in die Kanäle 40 einzuführenden Enden einen Winkel von etwa 90° mit der Ebene des Kontaktierungsabschnitts 18.

Bei der Herstellung der elektrischen Vorrichtung wird nun der Schaltungsträger 12 mit den daran gehaltenen Kontaktelementen 42 auf bzw. in das Gehäuseunterteil 14, insbesondere den Halteabschnitt 26 auf- bzw. eingesetzt, wobei gleichzeitig die Kontaktelemente 42 in die Kanäle 40 in dem Steckverbinderkörper des in der Verbindungslage angeordneten Schwenkabschnitts eingeführt werden. Dabei können sie in den Kanälen 40 verrastet werden. Die weitere Herstellung der jeweiligen elektrischen Vorrichtungen verläuft wie zuvor geschildert durch Zusammenfügen des Gehäuses.

### Bezugszeichenliste

- 10: Gehäuse
- 12: Schaltungsträger
- 14: Schaltungsabschnitt
- 16: elektrische bzw. elektronische Bauelemente
- 18: Kontaktierungsabschnitt
- 20: Kontaktierungsöffnungen
- 22: Gehäuseoberteil
- 24: Gehäuseunterteil
- 25: Aufnahmeabschnitt
- 26: Halteabschnitt
- 28: Boden
- 30: U-förmige Wand
- 32: Schwenkabschnitt
- 34: Steckverbinderkörper
- 36: Filmgelenk
- 38: Kragen
- 39: Rastleiste
- 40: Kanäle
- 42: Kontaktelemente
- 44: Kontaktierungsenden
- 46: U-förmige Wand
- 48: Deckelabschnitt
- 52: Trennwand
- 54: Anschlag
- 56: Sicherungselement
- 58: Rasthaken
- 60: Gehäuseoberteil
- 62: Streifen
- 64: Filmgelenk
- 66: Gehäuseunterteil
- 68: erstes Sicherungselement
- 69: Filmgelenk
- 70: Flanken
- 72: zweites Sicherungselement

- S: Steckrichtung

## Patentansprüche

1. Elektrische Vorrichtung mit
einem Schaltungsträger (12), der einen Schaltungsabschnitt (14) und einen mit dem Schaltungsabschnitt (14) mechanisch und elektrisch verbundenen Kontaktierungsabschnitt (18) umfasst, und
einem Gehäuse (10), das einen Aufnahmeabschnitt (25) zur Aufnahme wenigstens des Schaltungsabschnitts (14) des Schaltungsträgers (12) und einen mit dem Aufnahmeabschnitt (25) schwenkbar verbundenen Schwenkabschnitt (32) mit einem einstückig ausgebildeten Steckverbinderkörper (34) zur Aufnahme von mit dem Kontaktierungsabschnitt (18) elektrisch zu verbindenden oder verbundenen Kontaktelementen (42) aufweist und das wenigstens teilweise den Schaltungsträger (12) aufnimmt,
wobei der Schwenkabschnitt (32) aus einer Verbindungslage, in der der Kontaktierungsabschnitt (18) elektrisch mit in dem Steckverbinderkörper (34) gehaltenen Kontaktelementen (42) verbindbar ist oder an dem Kontaktierungsabschnitt (18) bereits gehaltene Kontaktelemente (42) in den Steckverbinderkörper (34) des Schwenkabschnitts (32) einführbar sind, in eine Gebrauchslage schwenkbar ist, und
wobei der Kontaktierungsabschnitt (18) des Schaltungsträgers (12) mit wenigstens einem Kontaktelement (42) in dem Steckverbinderkörper (34) des Gehäuses (10) elektrisch verbunden ist,
**dadurch gekennzeichnet,**
**dass** der Kontaktierungsabschnitt (18) gegenüber dem Schaltungsabschnitt (14) schwenkbar ist.

2. Elektrische Vorrichtung nach Anspruch 1,
**dadurch gekennzeichnet,**
**dass** der Schwenkabschnitt (32) einstückig mit dem Aufnahmeabschnitt (25) ausgebildet und über ein Filmgelenk (36; 69) verbunden ist.

3. Elektrische Vorrichtung nach Anspruch 1 oder 2,
**dadurch gekennzeichnet,**
**dass** sich die Flanken (70) des Filmgelenks (69) und/oder die dem Filmgelenk unmittelbar benachbarten Bereiche des Gehäuses (10) in der Gebrauchslage aufeinander abstützen.

4. Elektrische Vorrichtung nach einem der vorhergehenden Ansprüche,
**dadurch gekennzeichnet,**
**dass** der Aufnahmeabschnitt einstückig und wenigstens teilweise hülsen- oder taschenförmig mit wenigstens einer Öffnung ausgebildet ist, und
**dass** die Öffnung durch Schwenken des Schwenkabschnitts aus der Verbindungslage in die Gebrauchslage wenigstens teilweise verschließbar ist.

5. Elektrische Vorrichtung nach einem der Ansprüche 1 bis 4,
**dadurch gekennzeichnet,**
**dass** das Gehäuse (10) wenigstens zwei getrennte Gehäuseteile (22, 24) aufweist, die zusammengefügt den Aufnahmeabschnitt (25) bilden.

6. Elektrische Vorrichtung nach einem der Ansprüche 1 bis 4,
**dadurch gekennzeichnet,**
**dass** das Gehäuse (10) zwei schwenkbar miteinander verbundene, aufeinander schwenkbare Gehäuseteile (60, 66) aufweist, die in eine Gehäuseendlage schwenkbar sind, in der sie zusammengefügt den Aufnahmeabschnitt (25) bilden.

7. Elektrische Vorrichtung nach Anspruch 6,
**dadurch gekennzeichnet,**
**dass** die beiden Gehäuseteile (60, 66) über Filmgelenke (64, 69) mit dem Schwenkabschnitt (32) verbunden sind.

8. Elektrische Vorrichtung nach einem der Ansprüche 5 bis 7,
**dadurch gekennzeichnet,**
**dass** eines bzw. einer der Gehäuseteile (24; 66) so ausgebildet ist, dass der darin bzw. daran gehaltene Schaltungsabschnitt (14) auf einer Lötseite zugänglich ist, wenn der Schaltungsabschnitt (14) in bzw. an dem Gehäuseteil (24; 66) gehalten ist und die Gehäuseteile (22, 24; 60, 66) nicht zusammengefügt sind.

9. Elektrische Vorrichtung nach einem der Ansprüche 5 bis 8,
**dadurch gekennzeichnet,**
**dass** das bzw. der mit dem Schwenkabschnitt (32) verbundene Gehäuseteil (24; 60, 66) in einer Herstellungslage des Schwenkabschnitts (32) in einer durch den Steckverbinderkörper (34) gegebenen Steckrichtung keine Hinterschneidungen aufweist.

10. Elektrische Vorrichtung nach einem der vorhergehenden Ansprüche,
**dadurch gekennzeichnet,**
**dass** in dem Steckverbinderkörper (34) Kontaktelemente (42) mit Kontaktierungsenden (44) zur Verbindung mit dem Kontaktierungsabschnitt (18) des Schaltungsträgers (12) angeordnet sind, und
**dass** in der Verbindungslage die Kontaktierungsenden (44) im Wesentlichen orthogonal zu einer Ebene verlaufen, die durch den Schaltungsabschnitt (14) des in dem Gehäuse (10) oder einem Teil desselben gehaltenen Schaltungsträgers (12) bestimmt ist.

11. Elektrische Vorrichtung nach einem der vorhergehenden Ansprüche,
**dadurch gekennzeichnet,**
**dass** der Steckverbinderkörper (34) im Wesentlichen linear und parallel zu einer durch den Steckverbinderkörper (34) bestimmten Steckrichtung verlaufende Kanäle (40) zur Aufnahme von Kontaktelementen (42) aufweist.

12. Elektrische Vorrichtung nach einem der vorhergehenden Ansprüche,
**dadurch gekennzeichnet,**
**dass** in der Gebrauchslage eine durch den Steckverbinderkörper (34) bestimmte Steckrichtung im Wesentlichen parallel zu einer durch den Schaltungsabschnitt (14) des in dem Gehäuse (10) gehaltenen Schaltungsträgers (12) bestimmten Ebene orientiert ist.

13. Elektrische Vorrichtung nach einem der vorhergehenden Ansprüche,
**dadurch gekennzeichnet,**
**dass** das Gehäuse Sicherungsmittel (39, 56, 58; 68, 72) zur Sicherung des Schwenkabschnitts (32) in der Gebrauchslage aufweist.

14. Elektrische Vorrichtung nach einem der vorhergehenden Ansprüche,
**dadurch gekennzeichnet,**
**dass** der Schaltungsträger (12) wenigstens eine flexible Trägerfolie umfasst.

15. Elektrische Vorrichtung nach Anspruch 13,
**dadurch gekennzeichnet,**
**dass** der Kontaktierungsabschnitt und/oder der Schaltungsabschnitt mechanisch verstärkt sind.

16. Elektrische Vorrichtung nach Anspruch 13,
**dadurch gekennzeichnet,**
**dass** der Kontaktierungsabschnitt und/oder der Schaltungsabschnitt eine im Wesentlichen starre Platine aufweisen und dass der Kontaktierungsabschnitt und der Schaltungsabschnitt durch einen flexiblen Flachleiter oder eine flexible gedruckte Schaltung elektrisch und mechanisch miteinander verbunden sind.

17. Schaltungsträger mit einem Schaltungsabschnitt, einem mit dem Schaltungsabschnitt mechanisch und elektrisch verbundenen, gegenüber dem Schaltungsabschnitt schwenkbaren Kontaktierungsabschnitt und einem mit dem Kontaktierungsabschnitt einstückig ausgebildeten Steckverbinderkörper zur Aufnahme von mit dem Kontaktierungsabschnitt elektrisch zu verbindenden Kontaktelementen, wobei der Kontaktierungsabschnitt aus einer Verbindungslage, in der der Kontaktierungsabschnitt elektrisch mit in dem Steckverbinderkörper gehaltenen Kontaktelementen verbindbar ist, in eine Gebrauchslage schwenkbar ist.

18. Verfahren zur Herstellung einer elektrischen Vorrichtung nach einem der Ansprüche 1 bis 16, bei dem
der Schaltungsträger (12) mit dem Schaltungsabschnitt (14) in dem Gehäuse (10) oder in oder an einem Gehäuseteil (24; 66) zur Bildung des Aufnahmeabschnitts (25) angeordnet wird,
der Kontaktierungsabschnitt (18) mit Kontaktelementen (42) in dem Steckverbinderkörper (34) des in seiner Verbindungslage angeordneten Schwenkabschnitts (32) verbunden wird oder an dem Kontaktierungsabschnitt bereits gehaltene Kontaktelemente in den Steckverbinderkörper des Schwenkabschnitts in der Verbindungslage eingeführt werden, und
der Schwenkabschnitt (32) in die Gebrauchslage geschwenkt wird.

19. Verfahren nach Anspruch 18,
**dadurch gekennzeichnet,**
**dass** vor einem Schwenken des Schwenkabschnitts (32) in die Gebrauchslage ein komplementärer Steckverbinder mit dem Steckverbinderkörper (34) des Gehäuses (10) zusammengesteckt wird.

## Claims

1. An electrical apparatus comprising
a circuit carrier (12), which includes a circuit section (14) and a contacting section (18) which is mechanically and electrically connected to the circuit section (14), and a housing (10) which has a receiving section (25) for receiving at least the circuit section (14) of the circuit carrier (12) and a pivotable section (32) which is pivotally connected to the receiving section (25) and has a plug connector body (34) made in one piece for receiving contact elements (42) which are electrically connected to or which are to be electrically connected to the contacting section (18), with said housing at least partly receiving the circuit carrier (12),
wherein the pivotable section (32) is pivotable into a utilization position from a connection position, in which the contacting section (18) can be electrically connected to the contact elements (42) which are held in the plug connector body (34) or in which contact elements (42) which are already held at the contacting section (18) can be introduced into the plug connector body (34) of the pivotable section (32), and
wherein the contacting section (18) of the circuit carrier (12) is electrically connected to at least one contact element (42) in the plug connector body (34) of the housing (10),
**characterized in that**
the contacting section (18) is pivotable with respect to the circuit section (14).

2. An electrical apparatus in accordance with claim 1, **characterized in that** the pivotable section (32) is formed in one piece with the receiving section (25) and is connected to it via a film hinge (36; 69).

3. An electrical apparatus in accordance with claim 1 or claim 2, **characterized in that** the flanks (70) of the film hinge (69) and/or the regions of the housing (10) which are directly adjacent to the film hinge are supported on one another in the utilization position.

4. An electrical apparatus in accordance with any one of the preceding claims, **characterized in that** the receiving section is formed in one piece and at least partly in the manner of a sleeve or a pocket with at least one opening;
and **in that** the opening can be at least partly closed by pivoting of the pivotable section from the connection position into the utilization position.

5. An electrical apparatus in accordance with any one of the claims 1 to 4, **characterized in that** the housing (10) has at least two separate housing parts (22, 24) which, when fitted together, form the receiving section (25).

6. An electrical apparatus in accordance with any one of the claims 1 to 4, **characterized in that** the housing (10) has two housing parts (60, 66) which are pivotally connected to one another and can be pivoted towards one another into a final housing position
in which they form the receiving section (25) when fitted together.

7. An electrical apparatus in accordance with claim 6, **characterized in that** the two housing parts (60, 66) are connected via film hinges (64, 69) to the pivotable section (32).

8. An electrical apparatus in accordance with any one of the claims 5 to 7, **characterized in that** one of the housing parts (24; 66) is formed in such a manner that the circuit section (14) which is held therein or thereon is accessible from a soldering side when the circuit section (14) is held in or on the housing part (24; 66) and the housing parts (22, 24; 60, 66) are not fitted together.

9. An electrical apparatus in accordance with any one of the claims 5 to 8, **characterized in that**, in a production position of the pivotable section (32), the housing part (24; 60, 66), which is connected to the pivotable section (32, has no undercuts in a plugging direction which is given by the plug connector body (34).

10. An electrical apparatus in accordance with any one of the preceding claims, **characterized in that** contact elements (42) with contacting ends (44) for connection to the contacting section (18) of the circuit carrier (12) are arranged in the plug connector body (34); and **in that**, in the connection position, the contacting ends (44) extend substantially orthogonally to a plane which is determined by the circuit section (14) of the circuit carrier (12) which is held in the housing (10) or in a part of it.

11. An electrical apparatus in accordance with any one of the preceding claims, **characterized in that**, for receiving contact elements (42), the plug connector body (34) has passages (40) which extend in a substantially linear and parallel manner to a plugging direction which is determined by the plug connector body (34).

12. An electrical apparatus in accordance with any one of the preceding claims, **characterized in that**, in the utilization position, a plugging direction which is determined by the plug connector body (34) is oriented substantially parallel to a plane which is determined by the circuit section (14) of the circuit carrier (12) which is held in the housing (10).

13. An electrical apparatus in accordance with any one of the preceding claims, **characterized in that** the housing has securing means (39, 56, 58; 68, 72) for securing the pivotable section (32) in the utilization position.

14. An electrical apparatus in accordance with any one of the preceding claims, **characterized in that** the circuit carrier (12) comprises at least one flexible carrier film.

15. Electrical apparatus in accordance with claim 13, **characterized in that** the contacting section and/or the circuit section is/are mechanically reinforced.

16. Electrical apparatus in accordance with claim 13, **characterized in that** the contacting section and/or the circuit section has/have a substantially rigid board; and **in that** the contacting section and the circuit section are electrically and mechanically connected to one another by a flexible flat conductor or a flexible printed circuit.

17. A circuit carrier comprising a circuit section, a contacting section which is mechanically and electrically connected to the circuit section and which is pivotable with respect to the circuit section, and a plug connector body which is formed in one piece with the contacting section for receiving contact elements which are to be electrically connected to the contacting section, wherein the contacting section is pivotable into a utilization position out of a connection position, in which the contacting section can be electrically connected to the contact elements which are held in the plug connector body.

18. A method for the manufacture of an electrical apparatus in accordance with any one of the claims 1 to 16, in which
the circuit carrier (12) is arranged with the circuit section (14) in the housing (10) or in or on a housing part (24; 66) for forming the receiving section (25),
the contacting section (18) is connected to contact elements (42) in the plug connector body (34) of the pivotable section (32), which is arranged in its connection position, or contact elements which are already held at the contacting section are introduced into the plug connector body of the pivotable section in the connection position, and
the pivotable section (32) is pivoted into the utilization position.

19. A method in accordance with claim 18, **characterized in that**, prior to a pivoting of the pivotable section (32) into the utilization position, a complementary plug connector is plugged to the plug connector body (34) of the housing (10).

## Revendications

1. Dispositif électrique comportant
un support de circuits (12) qui comprend une partie circuits (14) et une partie de mise en contact (18) reliée mécaniquement et électriquement à la partie circuits (14), ainsi qu'un boîtier (10) qui comporte une partie de réception (25) pour recevoir au moins la partie circuits (14) du support de circuits (12) et une partie de pivotement (32) reliée en pivotement à la partie de réception (25), avec un corps de connecteur à fiches (34) réalisé d'un seul tenant destiné à recevoir des éléments de contact (42) à relier ou reliés électriquement à la partie de mise en contact (18), et qui reçoit au moins partiellement le support de circuits (12),
la partie de pivotement (32) pouvant pivoter dans une position d'utilisation depuis une position de liaison dans laquelle la partie de mise en contact (18) peut être reliée électriquement à des éléments de contact (42) maintenus dans le corps de connecteur à fiches (34), ou dans laquelle des éléments de contact (42), déjà maintenus sur la partie de mise en contact (18), peuvent être introduits dans le corps de connecteur à fiches (34) de la partie de pivotement (32), et
la partie de mise en contact (18) du support de circuits (12) étant reliée électriquement à au moins un élément de contact (42) dans le corps de connecteur à fiches (34) du boîtier (10),
**caractérisé**
**en ce que** la partie de mise en contact (18) peut pivoter par rapport à la partie circuits (14).

2. Dispositif électrique selon la revendication 1,
**caractérisé**
**en ce que** la partie de pivotement (32) est réalisée d'un seul tenant avec la partie de réception (25) et est reliée par un film-charnière (36 ; 69).

3. Dispositif électrique selon la revendication 1 ou 2,
**caractérisé**
**en ce que** les flancs (70) du film-charnière (69) et/ou les zones du boîtier (10), directement voisines au film-charnière, prennent appui les uns sur les autres dans la position d'utilisation.

4. Dispositif électrique selon l'une des revendications précédentes,
**caractérisé**
**en ce que** la partie de réception est réalisée d'un seul tenant et au moins en partie en forme de manchon ou de poche avec au moins une ouverture, et
**en ce que** l'ouverture peut être fermée au moins partiellement par pivotement de la partie de pivotement de la position de liaison à la position d'utilisation.

5. Dispositif électrique selon l'une des revendications 1 à 4,
**caractérisé**
**en ce que** le boîtier (10) comporte au moins deux parties de boîtier (22, 24) séparées qui forment lorsqu'elles sont assemblées la partie de réception (25).

6. Dispositif électrique selon l'une des revendications 1 à 4,
**caractérisé**
**en ce que** le boîtier (10) comporte deux parties de boîtier (60, 66) reliées entre elles à pivotement, pouvant pivoter l'une vers l'autre, qui peuvent pivoter dans une position finale du boîtier dans laquelle elles forment, assemblées, la partie de réception (25).

7. Dispositif électrique selon la revendication 6,
**caractérisé**
**en ce que** les deux parties de boîtier (60, 66) sont reliées par des films-charnières (64, 69) à la partie de pivotement (32).

8. Dispositif électrique selon l'une des revendications 5 à 7,
**caractérisé**
**en ce qu'**une des parties de boîtier (24 ; 66) est réalisée de manière que la partie circuits (14) maintenue dans celle-ci ou sur celle-ci soit accessible sur un côté de brasage, lorsque la partie circuits (14) est maintenue dans ou sur la partie de boîtier (24 ; 66) et les parties de boîtier (22, 24 ; 60, 66) ne sont pas assemblées.

9. Dispositif électrique selon l'une des revendications 5 à 8,
**caractérisé**
**en ce que** la partie de boîtier (24 ; 60, 66) reliée à la partie de pivotement (32) ne présente pas, dans une position de fabrication de la partie de pivotement (32), de détalonnages dans une direction d'enfichage définie par le corps de connecteur à fiches (34).

10. Dispositif électrique selon l'une des revendications précédentes,
**caractérisé**
**en ce que** dans le corps de connecteur à fiches (34) sont disposés des éléments de contact (42) avec des extrémités de mise en contact (44) pour la liaison avec la partie de mise en contact (18) du support de circuits (12), et en ce que dans la position de liaison, les extrémités de mise en contact (44) s'étendent sensiblement orthogonalement à un plan qui est déterminé par la partie circuits (14) du support de circuits (12) maintenue dans le boîtier (10) ou dans une partie de celui-ci.

11. Dispositif électrique selon l'une des revendications précédentes,
**caractérisé**
**en ce que** le corps de connecteur à fiches (34) comporte des canaux (40), s'étendant sensiblement linéairement et parallèlement à une direction d'enfichage déterminée par le corps de connecteur à fiches (34), pour recevoir des éléments de contact (42).

12. Dispositif électrique selon l'une des revendications précédentes,
**caractérisé**
**en ce que** dans la position d'utilisation, une direction d'enfichage déterminée par le corps de connecteur à fiches (34), est orientée sensiblement parallèlement à un plan déterminé par la partie circuits (14) du support de circuits (12) maintenu dans le boîtier (10).

13. Dispositif électrique selon l'une des revendications précédentes,
**caractérisé**
**en ce que** le boîtier comporte des moyens de sécurité (39, 56, 58 ; 68, 72) pour bloquer la partie de pivotement (32) dans la position d'utilisation.

14. Dispositif électrique selon l'une des revendications précédentes,
**caractérisé**
**en ce que** le support de circuits (12) comprend au moins une feuille de support flexible.

15. Dispositif électrique selon la revendication 13,
**caractérisé**
**en ce que** la partie de mise en contact et/ou la partie circuits sont renforcées mécaniquement.

16. Dispositif électrique selon la revendication 13,
**caractérisé**
**en ce que** la partie de mise en contact et/ou la partie circuits comportent une platine sensiblement rigide et en ce que la partie de mise en contact et la partie circuits sont reliées l'une à l'autre électriquement et mécaniquement par un conducteur plat flexible ou un circuit imprimé flexible.

17. Support de circuits comportant une partie circuits, une partie de mise en contact reliée mécaniquement et électriquement à la partie circuits et pouvant pivoter par rapport à la partie circuits, ainsi qu'un corps de connecteur à fiches, réalisé d'un seul tenant avec la partie de mise en contact, pour recevoir des éléments de contact à relier électriquement à la partie de mise en contact, la partie de mise en contact pouvant pivoter dans une position d'utilisation depuis une position de liaison dans laquelle la partie de mise en contact peut être reliée électriquement à des éléments de contact maintenus dans le corps de connecteur à fiches.

18. Procédé de fabrication d'un dispositif électrique selon l'une des revendications 1 à 16, dans lequel le support de circuits (12) est disposé avec la partie circuits (14) dans le boîtier (10) ou dans ou sur une partie de boîtier (24 ; 66) pour former la partie de réception (25),
la partie de mise en contact (18) est reliée à des éléments de contact (42) dans le corps de connecteur à fiches (34) de la partie de pivotement (32) disposée dans sa position de liaison, ou des éléments de contact déjà maintenus sur la partie de mise en contact sont introduits dans le corps de connecteur à fiches de la partie de pivotement, dans la position de liaison, et
la partie de pivotement (32) est pivotée dans la position d'utilisation.

19. Procédé selon la revendication 18,
**caractérisé**
**en ce qu'**un connecteur à fiches complémentaire est assemblé par enfichage au corps de connecteur à fiches (34) du boîtier (10), avant pivotement de la partie de pivotement (32) dans la position d'utilisation.
